# EUROPEAN PATENT APPLICATION

(11) **EP 1 921 751 A1**
(43) Date of publication of application: **14.05.2008**
(21) Application number: 07119141.5
(22) Date of filing: 24.10.2007
(51) Int. Cl.: H03M 1/68, G09G 3/00

(54) **Data driver and organic light emitting diode display device thereof**

(30) Priority: 09.11.2006 KR 20060110575
(71) Applicant: Samsung SDI Co., Ltd., Suwon-si Gyeonggi-do (KR)
(72) Inventor: Park, Yong-sung, Gyeonggi-do (KR)
(74) Representative: Hengelhaupt, Jürgen

(57) **Abstract**

A data driver for an OLED display device includes a shift register, a first data processing unit adapted to output a first voltage by employing upper bits of the digital data signal, and a second data processing unit adapted to output a second voltage employing lower bits of the digital data signal, where the analog data signal is generated to correspond to the first voltage and the second voltage.

## Description

### BACKGROUND OF THE INVENTION

### 1. Field of the Invention

The present embodiments relate to a data driver and an organic light emitting diode (OLED) display device thereof. More particularly, the present embodiments relate to a data driver capable of reducing a size of a D/A converter by constituting a shift register in two parts to obtain the D/A converter with a small area, and an OLED display device thereof.

### 2. Description of the Related Art

A flat panel display device may include a display region in which multiple pixels are arranged in an array on a substrate, and an image may be displayed by connecting scan lines and data lines to each of the pixels to selectively apply a data signal to the pixels.

Flat panel display devices may be classified into passive matrix type display devices and active matrix type display devices, depending on driving systems of pixels. The active matrix type display devices, which selectively turn on the light in every unit pixel, have been widely used due to favorable aspects of resolution, contrast, and response time.

The flat panel display devices have been employed as display devices or monitors of information appliances, e.g., personal computers, mobile phones, PDAs, etc. Also, liquid crystal display devices (LCDs) employing liquid crystal panels, plasma display panel (PDP) display devices employing plasma panels, etc., have been widely known in the art.

Recent years have seen the development of various light emitting diode display devices, which are light weight and small-sized when compared to cathode ray tubes. Particularly, OLED display devices having excellent luminous efficiency, luminance, viewing angle, and rapid response time have stood in the spotlight.

### SUMMARY OF THE INVENTION

Accordingly, a first aspect of the invention provides a data driver adapted to receive a digital data signal and generate an analog data signal. The data driver comprises a shift register, a first data processing unit and a second data processing unit. The first data processing unit is adapted to output a first voltage corresponding to upper bits of the digital data signal. The second data processing unit is adapted to output a second voltage corresponding to lower bits of the digital data signal. The analog data signal corresponds to the first voltage and the second voltage.

A second aspect of the invention provides an organic light emitting diode display device. The organic light emitting diode display device comprises a pixel unit adapted to display an image, a data driver adapted to generate an analog data signal from a digital data signal, and to transmit the analog data signal to the pixel unit, and a scan driver adapted to generate a scan signal and to transmit the scan signal to the pixel unit. The data driver is a data driver according to the first aspect of the invention.

A third aspect of the invention provides a method for driving an organic light emitting diode display device. The method comprises:

dividing a data signal, input in series, into upper bits and lower bits;

receiving the upper bits and outputting the received upper bits from a first data processing unit in parallel;

receiving the lower bits and outputting the received lower bits from a second data processing unit in parallel; and

generating an analog data signal by selecting first and second reference voltages employing the upper bits output in parallel, and distributing the selected first and second reference voltages employing the lower bits output in parallel.

### BRIEF DESCRIPTION OF THE DRAWINGS

The above and other features and advantages of the present invention will become more apparent to those of ordinary skill in the art by describing in detail exemplary embodiments thereof with reference to the attached drawings, in which:

FIG. 1 illustrates a circuit view of a pixel employed in a related art OLED display device;

FIG. 2 illustrates a view of a data driver for transmitting a data signal in the pixel of FIG. 1;

FIG. 3 illustrates a view of a first embodiment of an OLED display device;

FIG. 4 illustrates a block diagram of the first embodiment of the data driver of the OLED display device;

FIG. 5 illustrates a block diagram of a second embodiment of the data driver used in the OLED display device;

FIG. 6 illustrates a circuit view showing a D/A converter of FIG. 4 and FIG. 5;

FIG. 7 illustrates a circuit view of a data voltage generation unit connected to a switch unit in the D/A converter according to the present embodiments; and

FIG. 8 illustrates an equivalent circuit showing a resistance array for generating a grey level voltage.

### DETAILED DESCRIPTION OF THE INVENTION

The present invention will now be described more fully hereinafter with reference to the accompanying drawings, in which exemplary embodiments of the invention are illustrated. The invention may, however, be embodied in different forms and should not be construed as limited to the embodiments set forth herein. Rather, these embodiments are provided so that this disclosure will be thorough and complete.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. When one element is connected to another element, one element may be not only directly connected to another element but also indirectly connected to another element via another element. Irrelevant elements may be omitted for clarity. Like reference numerals refer to like elements throughout.

In a data driver according to the present embodiments and an OLED display device thereof, a reduction in the size of the data driver may be realized since the bit number processed in the D/A converter may be reduced by separately processing upper bit signals and lower bit signals in the data driver.

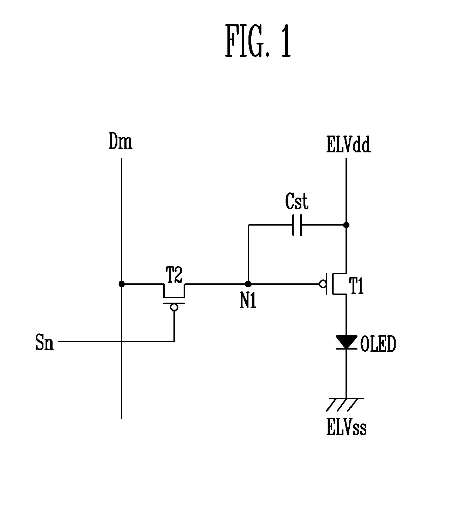

FIG. 1 illustrates a circuit view of a pixel. Referring to FIG. 1, the pixel may be connected to a data line Dm, a scan line Sn, and pixel power lines ELVdd and ELVss. The pixel may also include a first transistor T1, a second transistor T2, a capacitor Cst, and an OLED.

The first transistor T1 may have a source connected to the pixel power line ELVdd, a drain connected to the OLED, and a gate connected to a node N1. The second transistor T2 may have a source connected to the data line Dm, a drain connected to the node N1, and a gate connected to the scan line Sn. The capacitor Cst may be connected between the node N1 and the pixel power line ELVdd to maintain a voltage between the node N1 and the pixel power line ELVdd for a predetermined time. The OLED may include an anode electrode, a cathode electrode and a light emitting layer. The anode electrode may be connected to the drain of the first transistor T1, and the cathode electrode may be connected to the power source ELVss, which has a low electric potential. Light may therefore be emitted in the light emitting layer, and brightness may be controlled to correspond to an electric current capacity when an electric current flows from the anode electrode to the cathode electrode of the OLED to correspond to a voltage applied to the gate of the first transistor T1.

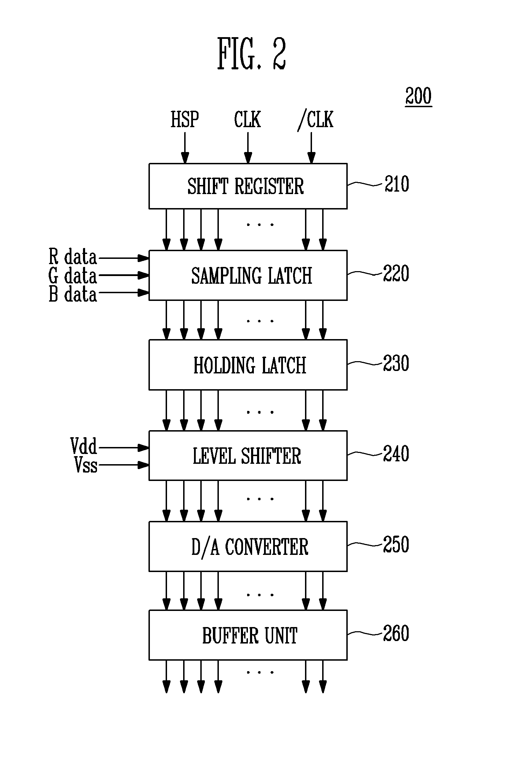

FIG. 2 illustrates a block diagram of a data driver 200 for transmitting a data signal in the pixel of FIG. 1. Referring to FIG. 2, the data driver 200 may include a shift register 210, a sampling latch 220, a holding latch 230, a level shifter 240, a D/A converter 250 and a buffer unit 260.

The shift register 210 may include multiple flip flops, and may control the sampling latch 220 to correspond to a clock signal CLK or /CLK and a synchronizing signal HSP. The sampling latch 220 may sequentially receive R data, G data, and B data signals of one row, and may output the received data signals in parallel, depending on a control signal of the shift register 210. A process in which the signals are sequentially received and outputted in parallel is referred to as SIPO (Serial In Parallel Out). The holding latch 230 may receive signals in parallel and output the received signals in parallel. A process in which the signals are received in parallel and outputted in parallel is referred to as PIPO (Parallel In Parallel Out). The level shifter 240 may convert the signals output from the holding latch 230 employing a positive supply voltage Vdd and a negative supply voltage Vss, to an operation voltage of the system to transmit the converted signals to the D/A converter 250. The D/A converter 250 may convert the signals, transmitted to the digital signal, to an analog signal, and the D/A converter 250 may select a corresponding grey level voltage to transmit the selected grey level voltage to the buffer unit 260. The buffer unit 260 may amplify the grey level voltage to transmit the amplified grey level voltage to the data lines.

When the data driver 200, as configured above, receives a 6-bit digital data signal and is operated, the D/A converter 250 may generate one analog data signal through a total of 6 wires. The pixel displaying an image may have a predetermined size, and its side may be about 42 µm in length. A wire leading from an input terminal of the D/A converter 250 may have a thickness of about 6 µm, and therefore a minimal thickness of the wires, i.e., wire bundle, may be about 36 µm so as to receive the 6-bit digital data signal. Accordingly, the D/A converter may increase in size as the wiring gets thicker. Also, the wiring may be thicker than the pixel because of the number of wires required when the 6-bit digital data signal is employed. Therefore, it may difficult to use the 6-bit digital data signal or even data signals having more than 6 bits.

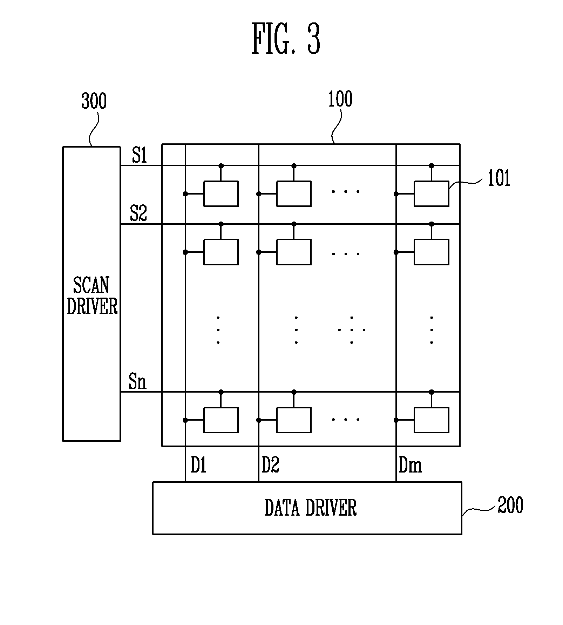

FIG. 3 illustrates a view showing of a first embodiment of an OLED display device. Referring to FIG. 3, the OLED display device may include a pixel unit 100, a data driver 200, and a scan driver 300.

The pixel unit 100 may include multiple data lines D1, D2...Dm-1, Dm, and multiple scan lines S1, S2...Sn-1, Sn, and may also include multiple pixels 101 formed in a region defined by multiple the data lines D1, D2...Dm-1, Dm, and multiple scan lines S1, S2...Sn-1, Sn. Each pixel 101 may include a pixel circuit and an OLED, and may generate a pixel current to allow the pixel current to flow to the OLED. The pixel current may flow to the pixels by employing a data signal transmitted to the pixel circuit through the multiple the data lines D1, D2...Dm-1, Dm. A scan signal may be transmitted to the pixel circuit through multiple the scan lines S1, S2...Sn-1, Sn.

The data driver 200 may be connected to the multiple the data lines D1, D2...Dm-1, Dm, and may generate the data signal to sequentially transmit the data signal of one row to the multiple data lines D1, D2...Dm-1, Dm. The data driver 200 may have a D/A converter to generate a grey level voltage, to thereby transmit the generated grey level voltage to the data lines D1, D2...Dm-1, Dm, where the grey level voltage may be an analog signal.

The scan driver 300 may be connected to multiple the scan lines S1, S2...Sn-1, Sn, and may generate a scan signal to transmit the generated scan signal to the multiple scan lines S1, S2...Sn-1, Sn. A certain row may be selected by the scan signal, then the data signal may be transmitted to the pixel 101 arrayed in the selected row, and the pixel may therefore generate an electric current to correspond to the data signal.

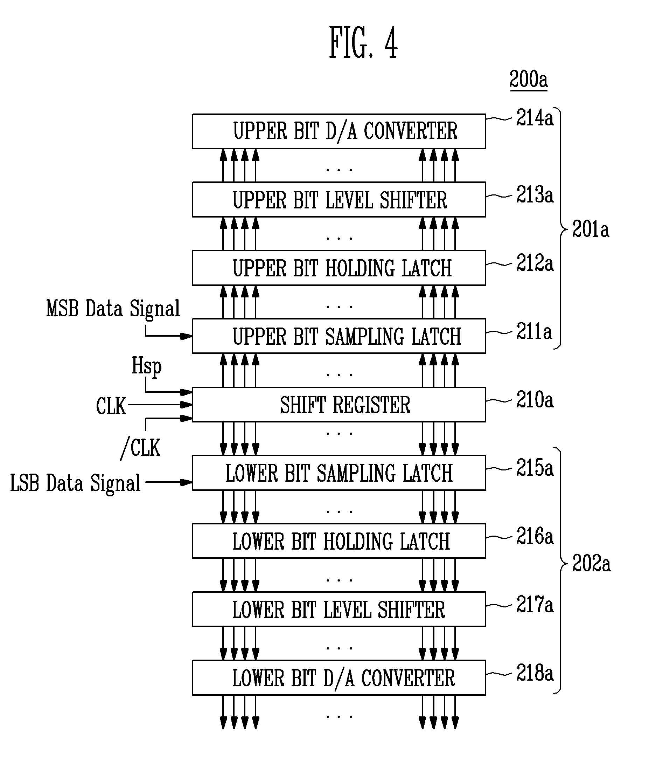

FIG. 4 illustrates a block diagram of the first embodiment of the data driver 200a of the OLED display device. Referring to FIG. 4, the data driver 200a may include a shift register 210a, and a first data processing unit 201a including an upper bit sampling latch 211 a, an upper bit holding latch 212a, an upper bit level shifter 213a, and an upper bit D/A converter 214a. The data driver 200a may also include a second data processing unit 202a including a lower bit sampling latch 215a, a lower bit holding latch 216a, a lower bit level shifter 217a, and a lower bit D/A converter 218a.

The shift register 210a may include multiple flip flops, and the shift register 210a may generate a control signal to correspond to a clock signal CLK or /CLK and a synchronizing signal Hsp, thereby transmitting the generated control signal to the first data processing unit 201a and the second data processing unit 202a.

When the first data processing unit 201a is operated, the upper bit sampling latch 211a may sequentially receive upper bit, i.e., most significant bit (MSB), data signals out of the data signals of one row, and may output the received MSB data signals in parallel by employing the SIPO process, depending on a control signal of the shift register 210a. The upper bit holding latch 212a may receive the MSB data signals transmitted from the upper bit sampling latch 211 a, and then may output the received MSB data signals in parallel by employing the PIPO process. The upper bit level shifter 213a may convert the data signals, output from the upper bit holding latch 212a, to an operation voltage of the system to transmit the converted MSB data signals to the upper bit D/A converter 214a.

During operation of the second data processing unit 202a, the lower bit sampling latch 215a may sequentially receive lower bit, i.e., least significant bit (LSB), data signals out of the data signals of one row, and may output the received LSB data signals in parallel, depending on the control signal of the shift register 210a. The lower level bit shifter 217a may convert the signals, output from the lower bit holding latch 216a, to an operation voltage of the system to transmit the converted LSB data signals to the lower bit D/A converter 218a.

When the digital data signal is a 6-bit signal, it may be divided into an upper 3 bits and a lower 3 bits, and be transmitted to the upper bit sampling latch 211a and the lower bit sampling latch 215a to process the data signal. Wires, in which the signal is input to the D/A converter, may be divided to transmit to the upper bit D/A converter 214a and the lower bit D/A converter 218a. Two sets of three wires, through which the signal is transmitted, may be formed on the shift register 210a and under the shift register 210a, respectively. An area occupied by the wires may thus be reduced to about half of the area as shown in FIG. 2. The location of the wires may be in a direction perpendicular to the data driver 200a. When a digital data signal is an 8-bit signal, two sets of four wires, through which the signal is transmitted, may be formed on the shift register 210a and under the shift register 210a, respectively. The area occupied by the wires may be smaller than the area of the wires in which the 6-bit signal is displayed in FIG. 2. Accordingly, the size of the data driver 200a may be reduced, since a large area is not occupied when the 8-bit signal is employed.

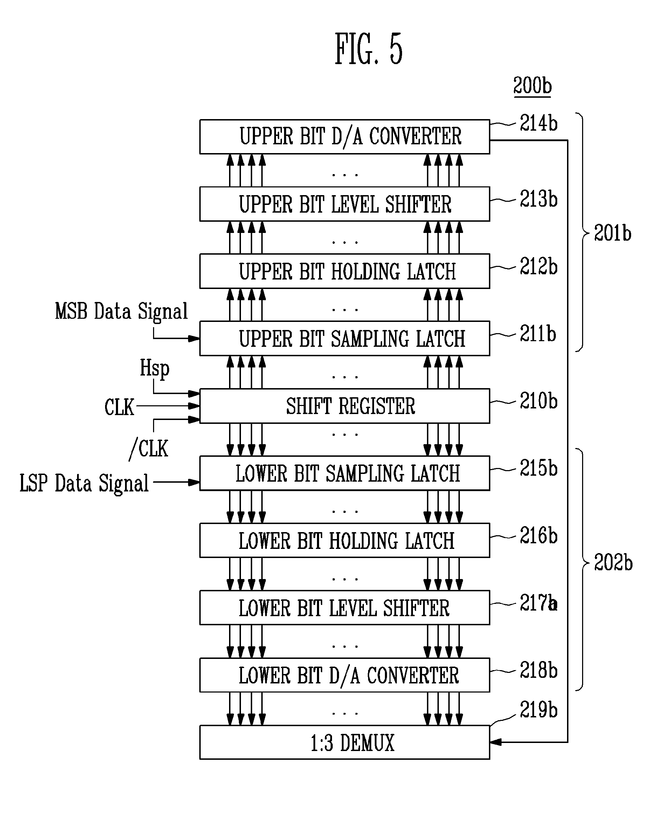

FIG. 5 illustrates a block diagram of the second embodiment of the data driver 200b used in the OLED display device. Referring to FIG. 5, the data driver 200b may include a shift register 210b, and a first data processing unit 201b including an upper bit sampling latch 211b, an upper bit holding latch 212b, an upper bit level shifter 213b and an upper bit D/A converter 214b. The data driver 200b may include a second data processing unit 202b including a lower bit sampling latch 215b, a lower bit holding latch 216b, a lower bit level shifter 217b and a lower bit D/A converter 218b. The upper bit D/A converter 214a and the lower bit D/A converter 218a may be connected to an 1:3 demux 219b. The term "demux" refers to demultiplexer.

The data driver 200b illustrated in FIG. 5 may be different from the data driver 200a illustrated in FIG. 4, where data driver 200b may further include the 1:3 demux 219b, and the size of the data driver may be further reduced since three pixels are connected to one output terminal of the data driver. The shift register 210b, the upper bit sampling latch 211b, the upper bit holding latch 212b, the upper bit level shifter 213b, the upper bit D/A converter 214b, the lower bit sampling latch 215b, the lower bit holding latch 216b, the lower bit level shifter 217b, and the lower bit D/A converter 218b, illustrated in FIG. 5, may be analogous to the corresponding shift register 210a, the upper bit sampling latch 211a, the upper bit holding latch 212a, the upper bit level shifter 213a, the upper bit D/A converter 214a, the lower bit sampling latch 215a, the lower bit holding latch 216a, the lower bit level shifter 217a, and the lower bit D/A converter 218a, illustrated in FIG. 4.

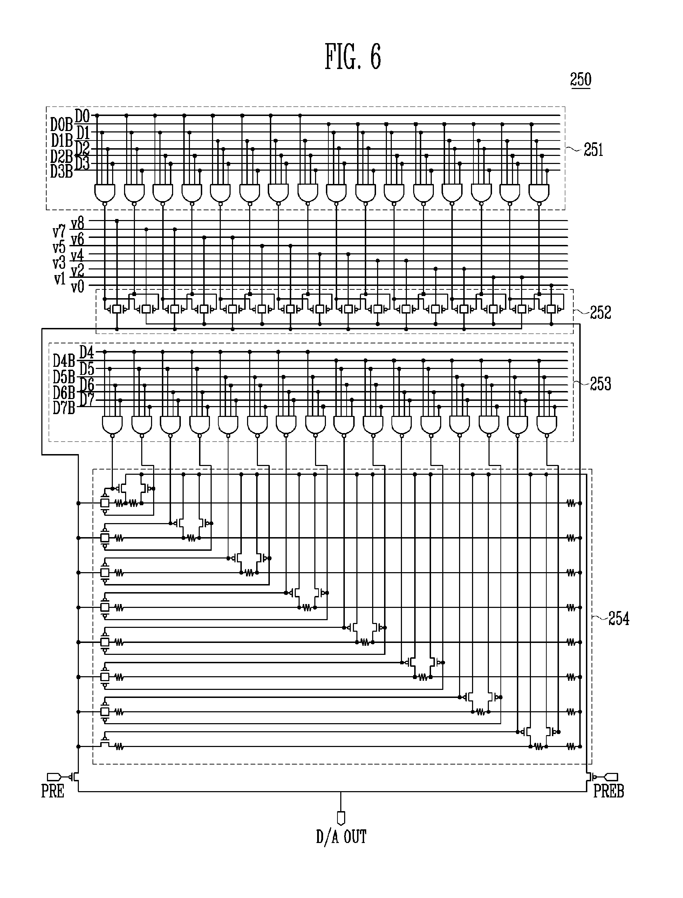

FIG. 6 illustrates a circuit view of a D/A converter 250 corresponding to the D/A converters 214a, 218a, 214b, and 218b of FIG. 4 and FIG. 5. Referring to FIG. 6, the D/A converter 250 may include a first decoder 251, a switch unit 252, a second decoder 253 and a data voltage generation unit 254. In the D/A converter 250, the data signal may include 8-bit signals to display 256 grey levels. The first decoder 251 and the switch unit 252 may be an upper bit demux, and the second decoder 253 and the data voltage generation unit 254 may be a lower bit demux, as in FIGS 4 and 5. The D/A converter 250 is illustrated as an equivalent circuit in FIG. 6, and the second decoder 253 and the data voltage generation unit 254 may appear to be adjacent to the first decoder 251 and the switch unit 252 on the circuit, but they may also be physically spaced apart from the first decoder 251 and the switch unit 252.

The first decoder 251 may generate 16 first decoding signals employing upper 4 bits of the data signal selected from data lines D0, D1, D2, D3, D0B, D1B, D2B, and D3B which are the upper bits of the data signal. The first decoder 251 may include 16 NAND gates, and may use the upper 4-bit signals of the data signal and their inverse (or bar) signals to generate 16 first decoding signals, and then may select one NAND gate out of the 16 NAND gates to output the first decoding signal. For convenience, the leftmost NAND gate is referred to as a first NAND gate, the next NAND gate is referred to as a second NAND gate, etc.

The switch unit 252 may select two reference voltage lines out of a total of 9 reference voltage lines V0, V1....V8 to select a first reference voltage and a second reference voltage out of the reference voltages, the second reference voltage being lower than the first reference voltage. Reference voltages V0, V1...V8 are preferably equidistant, i.e. every pair of neighbouring voltages will have the same voltage difference to them. The switch unit 252 may include 32 transistors, and the 32 transistors may form 16 pairs of transistors. The transistors forming one leftmost pair are referred to as a first transistor and a second transistor, and the transistors forming the next pair are referred to as a third transistor and a fourth transistor, etc.

The two transistors forming the pair each may have a source connected to one reference voltage line v8 out of the 9 reference voltage lines V0, V1....V8, and gates connected respectively to the first NAND gate and the second NAND gate. Accordingly, when the first decoding signal is output through the first NAND gate, the first transistor and the third transistor are in a turned-on state, and the first reference voltage and the second reference voltage are selected and transmitted to the data voltage generation unit 254. The transistors of each pair of transistors are configured to have different on-channel-resistances. Thus, even if the same input reference voltage is passed through either the left or the right transistor of each transistor pair, the effective voltage present at the output line will differ due to the different resistance present in the transistors. Accordingly, the eight pairs of reference voltages selected by block 251 will be subdivided to yield 16 output voltages of block 252.

The second decoder 253 may employ lower 4 bits of the data signal supplied by data lines D4, D5, D6, D7, D4B, D5B, D6B, and D7B, which are the lower bits of the data signal, to generate 16 second decoding signals. The second decoder 253 may include 16 NAND gates, and may employ the lower 4-bit signals of the data signal and their inverse signals to generate 16 second decoding signals, and then may select one NAND gate out of the 16 NAND gates to output the second decoding signal. For convenience, the leftmost NAND gate is referred to as a seventeenth NAND gate, the next NAND gate is referred to as an eighteenth NAND gate, etc.

The data voltage generation unit 254 may include eight voltage distribution units, and each of the voltage distribution units may include resistor arrays which may have four transistors and three resistors. The resistances of the resistors will be chosen such that each voltage distribution unit provides for a different voltage division ratio as is known in the art. Two transistors out of the four transistors may receive the output voltage of block 252 through the source, have a drain connected to one terminal of the resistor array, and have a gate connected respectively to the seventeenth NAND gate and the eighteenth NAND gate. The two remaining transistors may have a source connected respectively to both ends of the resistor arranged in a central region of the 3 resistor array, a drain connected to an output terminal, and a gate connected respectively to the seventeenth NAND gate and the eighteenth NAND gate.

The transistors may be connected respectively to output lines, the transistors being driven by a preset signal PRE and a preset inverse or bar signal PREB to provide an output D/A OUT.

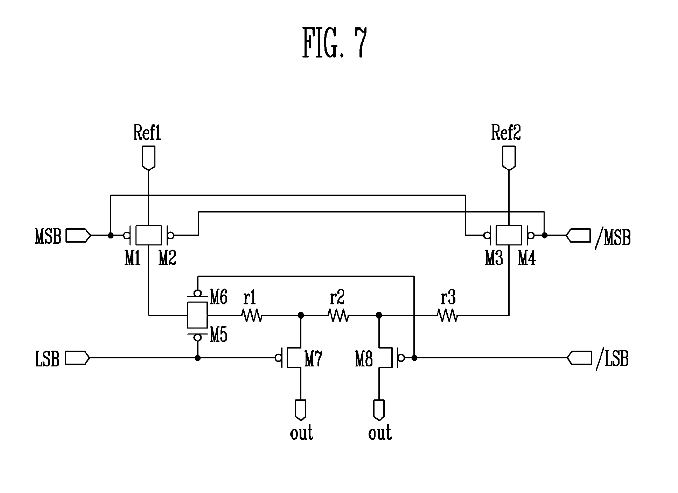

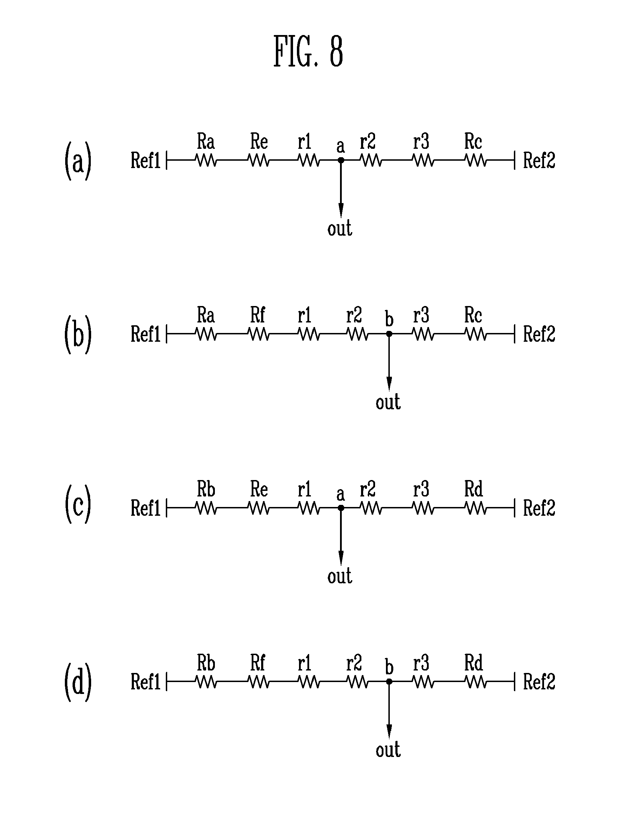

The selection of a first reference voltage Ref1 of the voltages V0, V1...V8 and a second reference voltage Ref2 of the voltages V0, V1...V8 by the first decoder 251 (see FIGS. 7 and 8) results in 16 grey levels which are divided by one of sixteen different divider rations selected by the second decoder 254, and therefore it may be possible to display 256 grey levels. By separating the D/A converter into a lower bit portion and into an upper bit portion, it is possible to also physically divide the D/A converter in two parts achieving the advantages explained with reference to Figs. 4 and 5. Only two wires will be required to connect the upper bit portion comprising blocks 251 and 252 of Fig. 6 to the lower bit portion comprising blocks 253 and 254 of Fig. 6.

Accordingly, the upper bit demux may employ the upper bits of the data signal to select a reference voltage, and the lower bit demux may employ the lower bits of the data signal and the reference voltage to generate a data voltage.

FIG. 7 illustrates a circuit view showing one of the data voltage generation units of block 254 connected to one of the transistor pairs of the switch unit 252 FIG. 6. For example, transistors M1, M2 may correspond to the left-most transistor pair of block 252 (the first transistor pair), transistors M3, M4 may correspond to the transistor pair next to it (the second transistor pair). Transistors M5, M7 may correspond to the transistors connected to the seventeenth NAND-gate, transistors M6, M8 may correspond to the transistors connected to the eighteenth NAND-gate. Accordingly, the inputs labeled "MSB" in FIG. 5 are connected to the respective outputs of two neighbouring NAND-gates of block 251, the inputs labeled "LSB" are connected to the respective outputs of two neighbouring NAND-gates of block 253.

Referring to FIG. 7, the switch unit may include a first transistor M1 and a second transistor M2 adapted to switch the first reference voltage Ref1 (which may be a high voltage), a third transistor M3 and a fourth transistor M4 adapted to switch the second reference voltage Ref2 (which may be a low voltage). The circuit may include a fifth transistor M5 and a sixth transistor M6 adapted to switch the first reference voltage Ref1. A resistor array may have first, second, and third resistors r1, r2, and r3 connected in series, where a seventh transistor M7 may be connected between the first resistor r1 and the second resistor r2 to transmit signals to an output terminal out. An eighth transistor M8 may be connected between the second resistor r2 and the third resistor r3 and be adapted to transmit signals to an output terminal out. An internal resistance of the first transistor M1 may be referred to as Ra, an internal resistance of the second transistor M2 may be referred to as Rb, an internal resistance of the third transistor M3 may be referred to as Rc, an internal resistance of the fourth transistor M4 may be referred to as Rd, an internal resistance of the fifth transistor M5 may be referred to as Re, and an internal resistance of the sixth transistor M6 may be referred to as Rf.

The first transistor M1 and the third transistor M3 may be controlled in the same manner employing the MSB. The second transistor M2 and the fourth transistor M4 may be controlled in the same manner employing the /MSB. The fifth transistor M5 and the seventh transistor M7 may be controlled in the same manner employing the LSB. The sixth transistor M6 and the eighth transistor M8 may be controlled in the same manner using the /LSB. The data voltage generation unit may utilize each of 4 resistor arrays depending on the switching operation of each of the transistors shown in configurations (a) to (d) of FIG. 8. Four grey level voltages may thus be generated from one first reference voltage Ref1 and one second reference voltage Ref2.

Accordingly, the eight voltage distribution units may generate a grey level voltage having the total 32 grey levels because 4 grey level voltages may be generated in one data voltage generation unit.

## Claims

1. A data driver adapted to receive a digital data signal and generate an analog data signal, comprising:
a shift register;
a first data processing unit adapted to output a first voltage corresponding to upper bits of the digital data signal; and
a second data processing unit adapted to output a second voltage corresponding to lower bits of the digital data signal,
wherein the analog data signal corresponds to the first voltage and the second voltage.

2. The data driver as claimed in claim 1, wherein the first data processing unit comprises:
an upper bit sampling latch adapted to receive the upper bits of the digital data signal in series and to store the upper bits of the digital data signal by employing a control signal of the shift register;
an upper bit holding latch adapted to receive the upper bits of the digital data signal from the upper bit sampling latch, and to output the received upper bits of the digital data signal in parallel;
an upper bit level shifter adapted to output a signal corresponding to the upper bits of the digital data signal at an operation voltage; and
an upper bit D/A converter adapted to generate the first voltage by employing the signal output from the upper bit level shifter.

3. The data driver as claimed in claim 2, wherein the upper bit D/A converter is adapted to generate a first reference voltage and a second reference voltage different from the first reference voltage.

4. The data driver as claimed in one of the preceding claims, wherein the second data processing unit comprises:
a lower bit sampling latch adapted to receive the lower bits of the digital data signal in series and to store the lower bits of the digital data signal by employing a control signal of the shift register;
a lower bit holding latch adapted to receive the lower bits of the digital data signal from the lower bit sampling latch, and to output the received lower bits of the digital data signal in parallel;
a lower bit level shifter adapted to output a signal corresponding to the lower bits of the digital data signal at an operation voltage; and
a lower bit D/A converter adapted to generate the second voltage employing the signal output from the lower bit level shifter.

5. The data driver as claimed in claim 4, wherein the lower bit D/A converter is adapted to output a signal corresponding to the second voltage.

6. The data driver as claimed in one of the preceding claims, wherein the first data processing unit and an output terminal of the second data processing unit are connected to a demultiplexer.

7. The data driver as claimed in claim 6, wherein the demultiplexer is an 1:3 demultiplexer.

8. An organic light emitting diode display device, comprising:
a pixel unit adapted to display an image;
a data driver adapted to generate an analog data signal from a digital data signal, and to transmit the analog data signal to the pixel unit; and
a scan driver adapted to generate a scan signal and to transmit the scan signal to the pixel unit,
wherein the data driver is a data driver according to one of the preceding claims.

9. A method for driving an organic light emitting diode display device, comprising:
dividing a data signal, input in series, into upper bits and lower bits;
receiving the upper bits and outputting the received upper bits from a first data processing unit in parallel;
receiving the lower bits and outputting the received lower bits from a second data processing unit in parallel; and
generating an analog data signal by selecting first and second reference voltages employing the upper bits output in parallel, and distributing the selected first and second reference voltages employing the lower bits output in parallel.

10. The method for driving an organic light emitting diode display device as claimed in claim 9, wherein the organic light emitting display device is an organic light emitting display device according to claim 8.
